(19) Europäisches Patentamt
European Patent Office
Office européen des brevets

(11) **EP 1 930 294 A1**

(12) **EUROPEAN PATENT APPLICATION**
published in accordance with Art. 153(4) EPC

(43) Date of publication:
**11.06.2008 Bulletin 2008/24**

(21) Application number: **06782694.1**

(22) Date of filing: **11.08.2006**

(51) Int Cl.:
*C01B 21/06* (2006.01)   *C30B 9/12* (2006.01)
*C30B 29/38* (2006.01)   *H01L 33/00* (2006.01)

(86) International application number:
**PCT/JP2006/315955**

(87) International publication number:
**WO 2007/023699 (01.03.2007 Gazette 2007/09)**

(84) Designated Contracting States:
**DE**

(30) Priority: **24.08.2005 JP 2005242470**

(71) Applicant: **Mitsubishi Chemical Corporation**
**Minato-ku**
**Tokyo 108-0014 (JP)**

(72) Inventors:
• **TAHARA, Takeshi**
  **Yokohama-shi**
  **Kanagawa 227-8502 (JP)**
• **SEKI, Yoshinori**
  **Yokohama-shi**
  **Kanagawa 227-8502 (JP)**

• **TERADA, Shigeru**
  **Yokohama-shi**
  **Kanagawa 227-8502 (JP)**
• **TAKEUCHI, Sachie**
  **Yokohama-shi**
  **Kanagawa 227-8502 (JP)**
• **ARITA, Youji**
  **Yokohama-shi**
  **Kanagawa 227-8502 (JP)**
• **KUBOTA, Kouhei**
  **Yokohama-shi**
  **Kanagawa 227-8502 (JP)**

(74) Representative: **Naylor, Matthew John et al**
**Mewburn Ellis LLP**
**York House,**
**23 Kingsway**
**London WC2B 6HP (GB)**

(54) **METHOD FOR PRODUCING GROUP 13 METAL NITRIDE CRYSTAL, METHOD FOR MANUFACTURING SEMICONDUCTOR DEVICE, AND SOLUTION AND MELT USED IN THOSE METHODS**

(57)   A process for producing a Group 13 metal nitride crystal, comprising performing the growth of a Group 13 metal nitride crystal in a solution or melt comprising an ionic solvent having dissolved therein a composite nitride containing a metal element belonging to Group 13 of the Periodic Table and a metal element other than Group 13 of the Periodic Table. According to this production process, a good-quality Group 13 metal nitride crystal can be produced under low or atmospheric pressure by an industrially inexpensive method.

Fig.4

**Description**

TECHNICAL FIELD

The present invention relates to a production process of a Periodic Table Group 13 metal nitride crystal such as GaN crystal, and a method for producing a semiconductor device by using the production process. The present invention also relates to solutions and melts for use in the production process and the production method.

BACKGROUND ART

A compound crystal of Group 13 metal and nitride, as represented by gallium nitride (GaN), is useful as a substance for use in a light-emitting diode, a laser diode, a high frequency-capable electronic device and the like. As for the practical production process of the crystal, in the case of GaN, a method of effecting a vapor phase epitaxial growth on a sapphire substrate or a substrate such as silicon carbide by an MOCVD (Metal Organic Chemical Vapor Deposition) process has been proposed (see, for example, Non-patent Reference 1).

However, in this method, the GaN crystal is epitaxially grown on a heterogeneous substrate differing in the lattice constant and thermal expansion coefficient and therefore, many lattice defects are present in the obtained GaN crystal. When such a GaN crystal allowing for the presence of many lattice defects is used, an adverse effect is caused on the activity of the electronic device, and satisfactory performance cannot be expressed for use in the applied field such as blue laser. Therefore, improvement of the quality of GaN crystal grown on a substrate and establishment of the technique for the production of GaN bulk single crystal are being strongly demanded.

At present, in the heteroepitaxial GaN crystal growth method by a vapor phase process, a complicated long step is required so as to decrease the defect concentration of GaN crystal. Therefore, aggressive studies are being recently made on the formation of GaN single crystal by a liquid phase process, and a high-pressure method of reacting nitrogen and Ga under high-temperature high-pressure conditions has been proposed (see, Non-patent Reference 2), but this method is difficult to implement in industry because of the severe reaction conditions. In order to solve this problem, many reports have been made on the GaN crystal growth method where the reaction conditions are set to a lower pressure. For example, a method of reacting Ga and $NaN_3$ under elevation of the pressure (see, Non-patent Reference 3), and a flux growth method (see, Patent Reference 3, Non-patent References 4, 5, 8 and 9) have been proposed. As for the flux, an alkali metal is often used, but even when an alloy melt obtained by adding an alkali metal to a Ga melt is used, the size of the GaN crystal can be hardly made large because the amount of N or GaN dissolved in the alloy melt is very small. Also, a method of synthesizing GaN by an ammonothermal process has been reported (see, Non-patent Reference 6), but industrialization of this method is not yet realized, because the obtained crystal has a problem in the crystal size and the number of lattice defects and moreover, the production apparatus is expensive.

Furthermore, a method of heating a mixture of GaN powder and alkali metal halide, thereby producing a GaN crystal, has been proposed (see, Patent Reference 1), but the solubility of GaN in an alkali metal halide is low and in order to stably dissolve nitrogen, the crystal growth needs to be performed under a high pressure, therefore, this is a disadvantageous method for performing the crystal growth in industry. The crystal growth using a mixture of GaN powder and alkali metal halide has been also reported in Non-patent Reference 7, but this is considered to be a similar technique to Patent Reference 1. Patent Reference 2 describes a technique of using a lithium compound as an auxiliary dissolving agent, but in this publication, a solution using a molten salt is not employed and since the crystal is grown from an alloy melt, the same problem as in Non-patent References 4 and 5 is incurred.

[Patent Reference 1] JP-A-2005-112718
[Patent Reference 2] Unexamined Chinese Patent Publication No. 1288079A
[Patent Reference 3] JP-A-2005-306709
[Non-patent Reference 1] J. Appl. Phys., 37, page 309 (1998)
[Non-patent Reference 2] J. Crystal Growth, 178, page 174 (1977)
[Non-patent Reference 3] J. Crystal Growth, 218, page 712 (2000)
[Non-patent Reference 4] J. Crystal Growth, 260, page 327 (2004)
[Non-patent Reference 5] Kinzoku (Metals), Vol. 73, No. 11, page 1,060 (2003)
[Non-patent Reference 6] Acta Physica Polonica A, Vol. 88, page 137 (1995)
[Non-patent Reference 7] J. Crystal Growth, Vol. 281, page 5 (2005)
[Non-patent Reference 8] J. Mater. Sci. Ele., 16, Paragraph 29 (2005)
[Non-patent Reference 9] J. Crystal Growth, 284, page 91 (2005)

DISCLOSURE OF THE INVENTION

Problems to be solved by the Invention

As described above, in the heteroepitaxial crystal growth method on a substrate by a vapor phase process, a Group 13 metal nitride crystal with less lattice defects cannot be obtained. In other methods using a high pressure, the apparatus becomes large-scaled and the profitability is low. In the ammonothermal method using an ammonia in a supercritical state, the apparatus and materials used are very expensive. Also, in the method using an alkali metal as a flux or the like, the solubility of nitrogen is low at a low temperature and this gives rise to a problem in terms of the uniformity of liquid phase in the reaction system. Thus, there still remain problems to be solved for realizing the industrial utilization.

The present invention has been made to solve these problems in conventional techniques and an abject of the present invention is to produce a good-quality Group 13 metal nitride crystal such as GaN crystal even under low or atmospheric pressure at a low cost in industry and provide a solution or melt for use in the production. Another object of the present invention is to provide a method for producing a semiconductor device such as light-emitting diode, laser diode or high frequency- or power IC-capable device, by using the above-described production process.

Means for solving the Problems

Taking into account those problems, the present inventors have made intensive studies on the method for growing a high-quality metal nitride crystal having a crystal size applicable to a semiconductor electronic device by an industrially utilizable and profitable process, as a result, the present invention has been accomplished.

More specifically, the object of the present invention can be attained by the following means, that is, a production process of a Group 13 metal nitride crystal, a production method of a semiconductor device, and a solution.

[1] A process for producing a Group 13 metal nitride crystal, comprising dissolving a composite nitride containing a metal element belonging to Group 13 of the Periodic Table and a metal element other than Group 13 of the Periodic Table in an ionic solvent to prepare a solution or a melt, and performing the growth of a Group 13 metal nitride crystal in the solution or melt.

[2] The process for producing a Group 13 metal nitride crystal as described in [1], wherein the ionic solvent mainly comprises a molten salt.

[3] The process for producing a Group 13 metal nitride crystal as described in [2], wherein the molten salt is one kind of metal halide or multiple kinds of metal halides.

[4] The process for producing a Group 13 metal nitride crystal as described in any one of [1] to [3], wherein the metal element other than Group 13 of the Periodic Table contained in the composite nitride is contained also in the ionic solvent.

[5] The process for producing a Group 13 metal nitride crystal as described in any one of [1] to [4], wherein the ratio of the total molar number of the metal element other than Group 13 of the Periodic Table contained in the solution or melt to the total molar number of the metal element belonging to Group 13 of the Periodic Table contained in the solution or melt is from 16 to 80.

[6] The process for producing a Group 13 metal nitride crystal as described in any one of [1] to [5], wherein the nitride of the metal element other than Group 13 of the Periodic Table contained in the composite nitride dissolves at a concentration of 1.0 mol% or more in the ionic solvent.

[7] The process for producing a Group 13 metal nitride crystal as described in any one of [1] to [6], wherein a Group 13 metal nitride crystal is grown by lowering the temperature of the solution or melt obtained after dissolving the composite nitride in the ionic solvent.

[8] The process for producing a Group 13 metal nitride crystal as described in any one of [1] to [7] wherein the dissolution site of causing the composite nitride to dissolve in the ionic solvent and the crystal growth site of allowing the Group 13 metal nitride crystal to grow are separated, and the temperature of the dissolution site is higher than the temperature of the growth site.

[9] The process for producing a Group 13 metal nitride crystal as described in any one of [1] to [8], wherein the Group 13 metal nitride crystal is grown on the surface of a seed crystal or on a substrate.

[10] The process for producing a Group 13 metal nitride crystal as described in any one of [1] to [9], wherein the concentration of the metal nitride component other than Group 13 metal in the solution or melt is controlled in the crystal growth site of allowing the Group 13 metal nitride crystal to grow.

[11] The process for producing a Group 13 metal nitride crystal as described in [10], wherein the metal nitride component other than Group 13 metal in the solution or melt is removed by evaporation, reaction, decomposition or diffusion from the crystal growth site.

[12] The process for producing a Group 13 metal nitride crystal as described in any one of [1] to [11], wherein the metal element other than Group 13 metal is an alkali metal element or an alkaline earth metal element.

[13] The process for producing a Group 13 metal nitride crystal as described in any one of [1] to [12], wherein the growth of a Group 13 metal nitride crystal is performed in a state of the solid phase of the composite nitride remaining in the crystal growth apparatus containing the solution or melt.

[14] The process for producing a Group 13 metal nitride crystal as described in any one of [1] to [13], wherein the crystal growth is performed in a reaction vessel comprising, as the main component, an oxide of an element belonging to Group 2 or Group 3 of the Periodic Table.

[15] The process for producing a Group 13 metal nitride crystal as described in [14], wherein the reaction vessel mainly comprises an oxide having a standard formation energy of -930 kJ/mol or less at 1,000K.

[16] The process for producing a Group 13 metal nitride crystal as described in any one of [1] to [15], wherein the crystal growth is performed under atmospheric pressure.

[17] The process for producing a Group 13 metal nitride crystal as described in any one of [1] to [16], wherein the crystal growth is performed in an argon atmosphere.

[18] The process for producing a Group 13 metal nitride crystal as described in any one of [1] to [17], wherein a doping element is caused to be present in the solution or melt to thereby grow a Group 13 metal nitride crystal doped with the element.

[19] The process for producing a Group 13 metal nitride crystal as described in [1] to [18], wherein the solution or melt is a sole liquidphase present in the crystal growth reaction system.

[20] The process for producing a Group 13 metal nitride crystal as described in any one of [1] to [19], wherein the composite nitride is synthesized in the molten salt.

[21] The process for producing a Group 13 metal nitride crystal as described in [2] or [3], wherein the molten salt is a molten salt subjected to a dehydration treatment in a melted state by flowing a halogen or a halide gas.

[22] The process for producing a Group 13 metal nitride crystal as described in any one of [2], [3] and [21], wherein the molten salt is a mixture of a metal halide and a nitride of a metal other than Group 13 of the Periodic Table.

[23] The process for producing a Group 13 metal nitride crystal as described in any one of [1] to [22], wherein the composite nitride is produced by a dry process.

[24] The process for producing a Group 13 metal nitride crystal as described in any one of [1] to [23], wherein the crystal growth is performed in a nitrogen-free atmosphere.

[25] A process for producing a Group 13 metal nitride crystal, comprising performing the growth of a Group 13 metal nitride crystal in a solution or melt having a nitrogen concentration $X_N$ represented by the following formula (1) :

[Formula 1]

$$X_N = K \cdot P^{1/2} \qquad \qquad \text{formula (1)}$$

wherein $X_N$ is a nitrogen concentration (mol%) in the solution or melt, K is a proportionality constant represented by the following formula (2), and P is a pressure (MPa) in the crystal growth apparatus containing the solution or melt,

[Formula 2]

$$K \geq 0.001T - 0.85 \qquad \qquad \text{formula (2)}$$

wherein T is a temperature (K) of the solution or melt.

[26] The process for producing a Group 13 metal nitride crystal as described in [25], wherein the growth of a Group 13 metal nitride crystal is performed at 10 MPa or less.

[27] The process for producing a Group 13 metal nitride crystal as described in [25] or [26], wherein the growth of a Group 13 metal nitride crystal is performed at 600 to 1,000°C.

[28] The process for producing a Group 13 metal nitride crystal as described in any one of [25] to [27], wherein the solution or melt is a solution or melt comprising an ionic solvent having dissolved therein a composite nitride containing a metal element belonging to Group 13 of the Periodic Table and a metal element other than Group 13 of the Periodic Table.

[29] A method for producing a semiconductor device, comprising producing a Group 13 metal nitride crystal by the production process described in any one of [1] to [28].

[30] A solution or melt comprising an ionic solvent having dissolved therein a composite nitride containing a metal element belonging to Group 13 of the Periodic Table and a metal element other than Group 13 of the Periodic Table.

[31] The solution or melt as described in [30], wherein the ionic solvent is a molten salt.

[32] The solution or melt as described in [30] or [31], wherein the ratio of the total molar number of the metal element other than Group 13 of the Periodic Table contained in the solution to the total molar number of the metal element belonging to Group 13 of the Periodic Table contained in the solution is from 16 to 80.

[33] The solution or melt as described in any one of [30] to [32], wherein the metal element other than Group 13 metal is an alkali metal element or an alkaline earth metal element.

[34] The solution or melt as described in any one of [30] to [33], wherein the ionic solvent is a metal halide.

[35] The solution or melt as described in any one of [30] to [34], wherein the ionic solvent is a mixture of multiple kinds of metal halides.

Effects of the Invention

According to the production process of the present invention, a good-quality Group 13 metal nitride bulk crystal can be produced under low or atmospheric pressure. In particular, the problem to be solved in conventional techniques, that is, generation of multinucleus under high pressure or reduction of nitrogen concentration in the liquid under low pressure, can be overcome and the seed growth of a crystal can be performed. More specifically, a composite nitride is dissolved in an ionic solvent at a high temperature and then seed-grown by lowering the temperature, or while dissolving a composite nitride in an ionic solvent in a high-temperature portion, a seed is placed in a low-temperature portion, whereby a thick-film or bulk crystal can be efficiently produced. Also, the crystal growth rate, the quality and the crystal size can be controlled by controlling the concentration of the dissolved metal nitride component other than Group 13 metal in the vicinity of the crystal growth interface.

By virtue of these advantages, according to the present invention, a Group 13 metal nitride crystal having a sufficiently large size for the application to a semiconductor device can be produced without passing through high-temperature and high-pressure steps by using a reaction vessel formed of a refractory material comprising a metal element belonging to Groups 2 and 3 of the Periodic Table, that is, a refractory material comprising an oxide of Mg, Ca, A1, Ti, Y, Ce or the like, in particular, a vessel formed of an inexpensive basic refractory material such as magnesium oxide, calcium oxide and zirconia.

The production method of a semiconductor device of the present invention comprises producing the Group 13 metal nitride crystal of the present invention. Therefore, according to the present invention, a semiconductor device capable of coping with power IC or high frequency can be produced and this is greatly advantageous in industry.

BRIEF DESCRIPTION OF THE DRAWINGS

Fig. 1, is a schematic explanatory view showing a crystal growth apparatus (1 of 3) suitably used in the production of the Group 13 metal nitride crystal of the present invention.

Fig. 2 is a schematic explanatory view showing a crystal growth apparatus (2 of 3) suitably used in the production of the Group 13 metal nitride crystal of the present invention.

Fig. 3 is a schematic explanatory view showing a crystal growth apparatus (3 of 3) suitably used in the production of the Group 13 metal nitride crystal of the present invention.

Fig. 4 is a schematic explanatory view showing a crystal growth apparatus (1 of 5) used in Examples.

Fig. 5 is a schematic explanatory view showing a crystal growth apparatus (2 of 5) used in Examples.

Fig. 6 is a schematic explanatory view showing one embodiment of a molten salt-purifying apparatus used in Examples.

Fig- 7 is an XRD pattern of the $Li_3GaN_2$ crystal obtained in Production Example.

Fig. 8 is an optical microphotograph of the GaN crystal obtained in Example 1.

Fig. 9 is an SEM photograph of the GaN crystal obtained in Example 2.

Fig. 10 is an XRD pattern of the GaN crystal obtained in Example 5.

Fig. 11 is a schematic explanatory view showing a crystal growth apparatus (3 of 5) used in Examples.

Fig. 12 is a schematic explanatory view showing a crystal growth apparatus (4 of 5) used in Examples.

Fig. 13 is an SEM photograph of the GaN crystal obtained in Example 16.

Fig. 14 shows the X-ray rocking curve measurement results of the GaN crystal obtained in Example 16
Fig. 15 is a schematic explanatory view showing a crystal growth apparatus (5 of 5) used in Examples.

Explanation of the numbers in the drawings

| | |
|---|---|
| 1 | GaN crystal |
| 2 | substrate or a seed |
| 3 | substrate- or crystal-holding and rotating mechanism |
| 4 | Ga-Li alloy |
| 5 | partition plate |
| 6 | molten salt |
| 7 | is nitrogen or argon |
| 8 | composite nitride |
| 9 | net |
| 10 | gas inlet tube |
| 11 | gas inlet tube |
| 12 | gas blowing tube |
| 13 | is nitrogen |
| 14 | reaction vessel (first reaction vessel) |
| 15 | is an electric furnace |
| 16 | gas blowing tube |
| 17 | Ga-Li-N thin film |
| 18 | partition plate |
| 19 | gas discharge port |
| 20 | gas inlet tube |
| 21 | purification vessel |
| 22 | porous filter |
| 23 | sample reservoir |
| 24 | hydrogen chloride gas |
| 25 | second reaction vessel |
| 26 | lid |

BEST MODE FOR CARRYING OUT THE INVENTION

The production process of a Group 13 metal nitride crystal, the production method of a semiconductor device, and the solution or melt for use in these production process and method of the present invention are described in detail below. In the following, the constitutional requirements are sometimes described based on representative examples of the embodiment of the present invention, but the present invention is not limited to such embodiments.
Incidentally, the numerical value range shown by using a term "from (numerical value A) to (numerical value B)" in the present specification means a range including the numerical values A and B as a lower limit value and an upper limit value, respectively. Also, the term "seed" as used in the present specification includes not only a Group 13 metal nitride crystal but also a heterogeneous substrate such as sapphire, SiC and ZnO, and a Group 13 metal nitride crystal formed by the crystal growth.

[Production Process of Group 13 Metal Nitride Crystal and solution or Melt for Use in the Production Process]

The production process of the present invention is characterized in that seed growth of a crystal is performed by dissolving a composite nitride containing a Group 13 metal and a metal element other than Group 13, in an ionic solvent (particularly, a molten salt).
The composite nitride containing a Group 13 metal and a metal element other than Group 13, which is used in the production process of the present invention, may be a composite nitride obtained by mixing a nitride powder of a Group 13 metal and a nitride powder of a metal other than Group 13 metal (for example, $Li_3N$ or $Ca_3N_2$) and then elevating the temperature to cause a solid phase reaction or may be a composite nitride synthesized in a molten salt. Furthermore, a composite nitride obtained by preparing an alloy of a metal contained in the above-described composite nitride and nitriding the alloy with a nitrogen gas or the like may also be used. Preferred examples of the Group 13 metal include Ga, Al, In, GaAl and GaIn. Examples of the metal element other than Group 13 include Li, Na, Ca, Sr, Ba and Mg, and among these, Li, Ca, Ba and Mg are preferred. Preferred examples of the composite nitride include $Li_3GaN_2$, $Ca_3Ga_2N_4$, $Ba_3Ga_2N_4$ and $Mg_3GaN_3$. The composite nitride for use in the present invention may be chemically synthesized or obtained by a dry process such as reactive sputtering and may be even a mixture of elements not necessarily forming a stoichiometric composition. Also, in the present invention, two or more kinds of composite nitrides may be used.

The composite nitride containing a Group 13 metal and a metal element other than Group 13, which is used in the production process of the present invention, becomes a raw material at the time of growing a Group 13 metal nitride crystal. In the present invention, this composite nitride may be easily synthesized usually by preparing an alloy of a Group 13 metal and a metal element other than Group 13 and dissolving the alloy while elevating the temperature in a nitrogen atmosphere. In a normal process such as ammonothermal process, a fine powder or fine crystal of the objective Group 13 metal nitride crystal is synthesized and then dissolved in a solvent. As compared with such a process, the raw material can be very easily prepared and this has a large industrial value. The composite nitride may also be synthesized by performing a solid-phase reaction between a fine powder of a Group 13 metal nitride crystal and a nitride of an element other than a Group 13 metal, though this process is inferior in the profitability. Furthermore, the composite nitride may not be a chemically synthesized crystalline composite nitride but may be, for example, a mixed nitride film deviated from the stoichiometric composition, which is produced on a sapphire substrate or a substrate such as quartz by reactive sputtering or the like of reacting a target comprising an alloy of those elements with a nitrogen plasma. When the composite nitride thin film formed by such a dry process is kept in contact with a molten salt, the nitride can gradually dissolve out from the nitride thin film into the molten salt to form a diffusion-governing nitride-dissolved phase in the vicinity of interface and the crystal growth can be easily achieved by placing a seed in this vicinity of interface. A characteristic feature of the crystal growth using a dry process is that even a nitride difficult to chemically synthesize can be easily produced.

The ionic solvent for use in the present invention is not particularly limited as long as it does not inhibit the reaction in the production process of the present invention. In the present invention, an ionic solvent having the following functions (A) to (D) is preferably selected:

(A) a function of dissolving the composite nitride to prepare a solution;
(B) a function of dissolving the produced Group 13 metal nitride crystal;
(C) a function of accelerating the precipitation of the Group 13 metal nitride crystal from the solution of melt; and
(D) a function of dissolving the nitride of a metal element other than Group 13 of the Periodic Table contained in the composite nitride.

In order to exert the function (A), for example, an ionic solvent containing a metal element other than Group 13 of the Periodic Table contained in the composite nitride may be used. This is because when the ionic solvent contains an ion of the same species as the ion contained in the composite nitride, the affinity of ion is high and the composite nitride is readily dissolved. In this point, for example, in the case where the composite nitride used is $Li_3GaN_2$, LiCl is preferably used as the ionic solvent.

The functions (B) and (C) are seemingly conflicting functions but these two points both are an important function for the crystal growth from a liquid phase. In order to precipitate a large-size high-quality crystal, it is preferred to appropriately control both dissolution and precipitation of the produced Group 13 metal nitride crystal.

If the ionic solvent does not have the function (B), the Group 13 metal nitride produced by the production process of the present invention is immediately precipitated as a solid matter, and a large-size high-quality crystal can be hardly obtained. Accordingly, the ionic solvent preferably has a function of dissolving the Group 13 metal nitride crystal.

In order to exert the function (B), for example, when $Li_3GaN_2$ is used as the composite nitride, a mixed ionic solvent of LiCl and $Li_3N$ may be used. This is because GaN dissolves in the solvent due to the presence of $Li_3N$. $Li_3N$ when present together with LiCl becomes a liquid phase at a low temperature and forms an ionic solvent. Even when only LiCl is used as the ionic solvent for dissolving the composite nitride, $Li_3N$ is produced as a by-product by the reaction of the present invention, and a mixed ionic solvent of LiCl and $Li_3N$ is formed within the system (see, formula (3) shown later), but in order to more effectively use the function (B), it is also preferred to use a mixed ionic solvent previously containing LiCl and $Li_3N$ and dissolve the composite nitride in the solvent.

The contents of the function (C) are as follows. The method for precipitating a Group 13 metal nitride crystal from the solution or melt obtained after dissolving the composite nitride in an ionic solvent includes, for example, a method of lowering the liquid temperature and a method of creating a temperature difference in the solution or melt. These methods both utilize the fact that the saturated dissolution amount of a Group 13 metal nitride dissolved in an ionic solvent can be decreased by lowering the temperature. Therefore, an ionic solvent bringing about large decrease in the saturated dissolution amount of the Group 13 metal nitride when lowering the temperature of the solution or melt is preferably used, because the amount of the obtained Group 13 metal nitride is increased and a large crystal can be obtained.

In order to exert the function (C), for example, an ionic solvent not containing the metal element belonging to Group 13 of the Periodic Table contained in the composite nitride may be used by adding it to an ionic solvent having the functions (A) and (B). In the case where the composite nitride used is $Li_3GaN_2$, NaCl is preferred. As for the ionic solvent having both the functions (B) and (C), for example, a mixed ionic solvent of LiCl and NaCl, or a mixed ionic solvent of LiCl, $Li_3N$ and NaCl, may be suitably used.

Furthermore, in order to exert the function (C), it is also preferred to remove $Li_3N$ from the crystal growth site of GaN. The reason therefor is that since GaN and $Li_3GaN_2$ are dissolved due to the presence of $Li_3N$ contained in $Li_3GaN_2$, the precipitation of GaN can be accelerated by appropriately removing $Li_3N$ from the crystal growth site.

For example, the concentration of the metal nitride other than Group 13 metal contained in the composite nitride is appropriately controlled in the crystal growth site or the temperature is controlled for appropriately controlling the functions (B) and (C) of the solvent, whereby a Group 13 metal nitride crystal can be obtained.

The contents of the function (D) are as follows. At the time of producing a Group 13 metal nitride from the composite nitride, a nitride of an element other than Group 13 metal contained in the composite nitride is produced as a by-product. In this case, when the by-product is precipitated as a solid matter, there may readily arise a problem that, for example, the solid matter is taken as an impurity into the Group 13 metal nitride crystal or works out to a crystal nucleus for the growth of a Group 13 metal crystal. Accordingly, the ionic solvent preferably has a function of dissolving a by-product, for example, a nitride of the element other than Group 13 contained in the composite nitride.

In order to exert the function (D), for example, in the case of using $Li_3GaN_2$ as the composite nitride, an LiCl capable of dissolving the by-product $Li_3N$ is preferably used for the solvent.

The ionic solvent for use in the present invention preferably comprises a molten salt as the main component. More specifically, a molten salt preferably occupies 50 wt% or more, more preferably 70 wt% or more, still more preferably 90 wt% or more, of the ionic solvent used.

The molten salt is not limited in its kind as long as it does not inhibit the epitaxial growth on a seed, but a molten salt having chemically high affinity for the nitride of metal element other than Group 13 metal element in the raw material composite nitride is preferred, and a molten salt capable of forming a compound in chemical equilibrium with the nitride is more preferred. Examples thereof include a halide, a carbonate, a nitrate and a sulfide. Also, for example, in the case where the nitride is $Li_3N$, a molten salt containing LiCl for which the nitride exhibits a large dissolution amount is preferred. In general, a halide being stable and ensuring high solubility of a nitrogen compound is preferably used. The molten salt is more preferably a compound which is a salt containing an alkali metal and/or an alkaline earth metal and is used for a production reaction of nitrogen ion source.

Specifically, the molten salt is preferably a molten salt comprising an alkali metal salt (e.g., Li, Na, K) and/or an alkaline earth metal salt (e.g., Mg, Ca, Sr). The molten salt is also preferably a metal halide such as LiCl, KCl, NaCl, $CaCl_2$, $BaCl_2$, CsCl, LiBr, KBr, CsBr, LiF, KF, NaF, LiI, NaI, $CaI_2$ and $BaI_2$, or preferably any one of LiCl, KCl, NaCl, CsCl, $CaCl_2$, $BaCl_2$ and a mixed salt thereof, because the melting point decreases.

In order to control the solubility of the composite nitride in the molten salt and the meltability of the Group 13 metal nitride, as described above, a mixture comprising a plurality of salts may also be used. The mixture comprising a plurality of salts may be prepared by introducing two or more kinds of salts as separate solid matters into a reaction system, and heating and melting these salts, but in view of uniformity in the system, the mixture is preferably prepared by heating and melting a mixed salt, for example, a mixed salt of LiCl and NaCl.

In the case where the molten salt contains an impurity such as water, a reactive gas is preferably blown thereinto to previously purify the molten salt. Examples of the reactive gas include hydrogen chloride, hydrogen iodide, hydrogen bromide, ammonium chloride, ammonium bromide, ammonium iodide, chlorine, bromine and iodine. For the chloride molten salt, use of hydrogen chloride is particularly preferred.

In order to increase the solubility of the composite metal nitride, a nitride of a metal element other than Group 13 metal element may also be added to the molten salt. Preferred examples of the nitride of a metal element other than Group 13 metal element include $Li_3N$ and $Ca_3N_2$.

In the production process of the present invention, a Group 13 metal nitride crystal or a substrate is preferably used as a seed (seed crystal) for the crystal growth. The shape of the seed is not particularly limited and may be plate-like or bar-like. The seed may also be a seed for the homoepitaxial growth or a seed for the heteroepitaxial growth. Specific examples thereof include a vapor-grown Group 13 metal nitride seed crystal such as GaN, InGaN and AlGaN.

Furthermore, a material used as a substrate in the vapor phase growth, for example, a metal oxide (such as sapphire, silica, ZnO and BeO), a silicon-containing material (such as SiC and Si), GaAs or the like, may also be used. As for the material of such a seed, a material having a lattice constant as close as possible to the lattice constant of the Group 13 metal nitride crystal grown by the present invention is preferably selected. In the case of using a bar-like seed crystal, it is also possible to produce a bulk crystal by growing the crystal first in the seed crystal portion and then performing crystal growth in the perpendicular direction while performing crystal growth also in the horizontal direction.

The reaction vessel for use in the present invention is preferably a reaction vessel comprising, as the main component, a thermally and chemically stable oxide. The "main component" as used herein means a component occupying 90 wt% or more in the oxide components contained in the material constituting the wall surface coming into contact with the solution or melt in the reaction vessel and is preferably a component occupying 95 wt% or more in the oxide components contained in the material constituting the wall surface coming into contact with the solution or melt in the reaction vessel. In the case where the reaction vessel comprises a uniform material, the main component is the same as a component occupying 90 wt% or more, preferably 95 wt% or more, in the oxide components contained in the material constituting the entire reaction vessel. The oxide here is preferably an oxide containing a metal element belonging to Groups 2 and 3 of the Periodic Table, such as Mg, Ca, A1, Ti, Y, Ce and La, more preferably a chemically stable oxide having a standard formation energy of -930 kJ/mol or less at 1,000 K, specifically, such as $Y_2O_3$, CaO, $La_2O_3$ and MgO, and still more preferably an oxide having a standard formation energy of -1,000 kJ/mol or less at 1,000 K, specifically, such as $Y_2O_3$, CaO and $La_2O_3$.

In the present invention, a composite nitride comprising a Group 13 metal and a metal element other than Group 13 metal is used as the raw material.
This is described below by taking, as an example, the case of using a composite nitride of gallium and lithium. The precipitation of GaN from a solution or melt after dissolving $Li_3GaN_2$ in a molten salt is represented by the following formula:

[Formula 3]

$$Li_3GaN_2 \Leftrightarrow GaN + Li_3N \qquad \text{formula (3)}$$

It is disclosed in J. Crystal Growth, 247, pp. 275-278 (2003) and Unexamined Chinese Patent Publication No. 1286079A to produce a GaN crystal by mixing under heating a GaN powder, a Ga metal, an LiGa alloy or the like with a lithium compound. However, in Unexamined Chinese Patent Publication No. 1288079A, the lithium compound is not a raw material of GaN but an auxiliary melting agent used to compensate for low solubility of GaN. Also, in the case of a metal melt such as Ga and LiGa, there is a problem that a concentration distribution is readily generated due to difference in the density among components in the metal melt and a uniform melt is difficult to prepare and control.

In order to solve such a problem, the present invention is characterized in that a uniform solution or melt containing nitrogen in a sufficiently large amount for the production of GaN is prepared by dissolving $Li_3GaN_2$ in a molten salt. $Li_3GaN_2$ is considered to dissolve by forming a chemical species such as ion species $GaN_2^{3-}$ in an ionic solvent. Therefore, when an ionic solvent is used, a uniform solution or melt having a high nitrogen concentration can be prepared under low or atmospheric pressure and this facilitates controlling the material-concentration distribution in the system and providing a stable growth environment for crystal, so that a large-size crystal can be grown.

On the other hand, in the conventional flux growth method described, for example, in Patent Document 3, an alkali metal such as Na and Li is added as an auxiliary melting agent so as to increase the dissolution amount of nitrogen for Ga, but the amount of nitrogen dissolved in a solution or melt is very small under low or atmospheric pressure as compared with the amount necessary for entirely nitriding Ga in the system. From this reason, in the flux method, the dissolution of nitrogen into a solution or melt from vapor phase is rate-limiting in the precipitation of GaN. If the pressure is low, a sufficiently high nitrogen concentration for the growth of GaN cannot be obtained and therefore, a high pressure needs to be applied to the vapor phase nitrogen so as to precipitate a GaN crystal, whereas if the pressure of the vapor phase nitrogen is too high for the crystal growth rate, this incurs a problem that many microcrystalline nuclei are generated to allow for production of innumerable GaN small crystals and the GaN crystal cannot grow large. Under the high pressure condition, it is difficult to appropriately control the pressure of vapor phase according to the crystal growth rate, and this is considered to be a cause of incapability of obtaining a large-size crystal by the conventional flux method.

In the present invention, for example, $Li_3GaN_2$ is used as the raw material and LiCl is used as the solvent, so that a sufficiently high nitrogen solubility can be obtained even under atmospheric or low pressure and the precipitation of GaN can be controlled not by the pressure but by a method allowing easy control of the precipitation.

In general, the amount of the vapor phase component dissolved into a liquid phase by gas-liquid equilibrium is expressed by the following formula (1) based on the Sievert's Law. According to formula (1), the dissolution amount of a gas into a liquid phase at a given pressure and a given temperature is determined by the value of proportionality constant K. The present invention is characterized by performing the growth of a GaN crystal by using a solution or melt having a high nitrogen concentration in which the proportionality constant K satisfies the following formula (2). Use of such a solution or melt satisfying the conditions of formulae (1) and (2) is not described in literatures regarding the conventional flux method and the like, and means for preparing such a solution or melt is also not suggested in those literatures.

[Formula 4]

$$X_N = K \cdot P^{1/2} \qquad \text{formula (1)}$$

wherein $X_N$ is a nitrogen concentration (mol%) in the solution or melt, K is a proportionality constant represented by the following formula (2), and P is a pressure (MPa) in the crystal growth apparatus containing the solution or melt.

[Formula 5]

$$K \geq 0.001T - 0.85 \qquad \text{formula (2)}$$

wherein T is a temperature (K) of the solution or melt.

In the present invention, the proportionality constant K in formula (1) preferably satisfies the following formula (2A):

[Formula 6]

$$K \geq 0.003T - 2.4 \qquad \text{formula (2A)}$$

wherein T is a temperature (K) of the solution or melt.

If the solution or melt has a nitrogen concentration smaller than the nitrogen concentration calculated by applying the range of K specified by formula (2) to formula (1), a large-size GaN crystal can be hardly precipitated due to the excessively small nitrogen concentration.

In the best mode for carrying out the present invention, a GaN crystal is grown under atmospheric or low pressure, but even when the vapor phase pressure is made higher, the present invention may be applied. However, under such a pressure condition, the nitrogen concentration in the solution or melt is not affected by the pressure, but rather, if the vapor phase pressure is too much elevated, a large number of microcrystals are precipitated due to spontaneous nuclear development and a large-size GaN crystal cannot be obtained. Accordingly, it is necessary that the value of P in formula (1) is not too large, that is, the value of K is within the range represented by formula (2).

As for the reaction atmosphere, the production process of the present invention may be practiced even in a system where the vapor phase does not contain nitrogen, for example, in an argon atmosphere. Argon can readily restrain oxygen from mingling as compared with nitrogen and when the crystal growth is performed in an argon atmosphere, mingling of oxygen into the crystal can be reduced. Incidentally, the term "reaction atmosphere" means the vapor phase component in the periphery of a reaction vessel containing a solution or melt obtained by dissolving $Li_3GaN_2$ in a molten salt.

Li is contained in $Li_3GaN_2$ and therefore, also in view of affinity at the dissolution or difference in the density between solvent ion and solute ion, the molten salt used as an ionic solvent preferably contains Li. In particular, the molten salt containing Li is preferably LiCl.

If the ratio of LiCl to $Li_3GaN_2$ is too small (the amount of LiCl is too small), $Li_3GaN_2$ is not sufficiently dissolved due to the small solvent amount and this incurs a problem that the amount of GaN obtained is small and a large crystal cannot be obtained. On the contrary, if the ratio of LiCl to $Li_3GaN_2$ is too large (the amount of LiCl is too large), the $Li_3GaN_2$ concentration in the solvent is decreased and this brings about a problem that crystal precipitation becomes difficult and a large crystal cannot be obtained. The ratio of the sum of Li in $Li_3GaN_2$ and Li in LiCl to Ga in $Li_3GaN_2$ used for the reaction is preferably from 16 to 80, more preferably from 18 to 70, still more preferably from 20 to 50. In Unexamined Chinese Patent Publication 1288079A, the ratio of Li to Ga is from 0.11 to 12. This is because the above-described known publication does not consider to use a Li-containing solvent. In order to produce a uniform solution or melt as in the present invention, LiCl is preferably used as the solvent and for this purpose, the ratio of Li to Ga needs to be larger than the value in that known publication.

The molten salt used preferably has a property of dissolving $Li_3N$ produced according to formula (3). If a molten salt not having a property of dissolving $Li_3N$ is used, the reaction of formula (3) from the solution or melt proceeds while involving simultaneous occurrence of precipitation of solid phase GaN and precipitation of solid phase $Li_3N$, and the crystal growth becomes difficult to control.

The molten alt may be a mixture of a plurality of compounds, for example, may be a mixture of a plurality of alkali metal halides. When a molten salt comprising a mixture of two or more alkali metal halide components is used as the solvent, a wide latitude of control is permitted at the time of adjusting the solubility of $Li_3GaN_2$ and the solubility of GaN to give optimal precipitation of GaN, and these can be adjusted to optimal solvent conditions for the crystal precipitation of GaN. Among various mixed molten salts of alkali metal halides, a mixed molten salt of LiCl and NaCl is preferred.

$Li_3N$ produced according to formula (3) dissolves in the molten salt of alkali metal halide and therefore, the $Li_3N$ concentration in the solvent increases. If the $Li_3N$ concentration is not controlled, the reaction of formula (3) reaches equilibrium and stops. The present inventors considered that from such a reason, the crystal grows at a low rate in conventional techniques and only a small crystal can be obtained, and have accomplished the present invention capable of providing means for solving this problem.

In the present invention, the $Li_3N$ concentration increasing in the solvent along with the progress of the reaction of formula (3) is removed by some means, whereby the concentration can be controlled and GaN can be precipitated. Examples of the method for controlling the $Li_3N$ concentration, which can be used, include evaporation, decomposition reaction, reaction with other chemical species (for example, W metal), and diffusion. The $Li_3N$ concentration may be controlled by using one of these methods or by using some methods thereof at the same time.

For example, as for the removal by evaporation, $Li_3N$ is continuously evaporated in $N_2$ flow and removed from the reaction system, whereby the crystal growth can be allowed to continuously proceed. The removal of $Li_3N$ by evaporation is inhibited under high pressure and the equilibrium of formula (3) can be hardly shifted to the right, as a result, the GaN solubility in the solution or melt decreases. Accordingly, the crystal growth is preferably performed under low pressure, specifically, at 10 MPa or less.

As for the removal by reaction, for example, when Ga metal is present in the molten salt, the $Li_3N$ concentration in the molten salt decreases resulting from the reactions of formulae (4) and (5) and the crystallization reaction according to formula (3) continuously proceeds. Li discharged from the reaction site by the reactions of formulae (4) and (5) is absorbed into the Ga metal and becomes an alloy. Also, $Li_3N$ may be removed by charging a substance capable of reacting with $Li_3N$ to form a nitride, such as W mesh, into the system.

Furthermore, when the molten salt as the solvent is used in a sufficiently large amount, by virtue of and as a result of diffusion, the $Li_3N$ concentration in the crystal growth part can be made to less change. As for the method of removing $Li_3N$ in the molten salt by decomposition, for example, hydrogen chloride or chlorine may be blown to decompose $Li_3N$ into LiCl, $N_2$ and $H_2$ (in the case of hydrogen chloride). In the case of causing the reaction to proceed more mildly, ammonium chloride may be supplied as a gas and hydrogen chloride produced by decomposition on the molten salt surface may be utilized.

In the growth of a Group 13 nitride crystal, the $Li_3N$ concentration in the system is appropriately controlled in this way, whereby a thick-film or bulk Group 13 metal nitride crystal can be grown without stopping by the equilibrium of formula (3). The quality and growth rate of the Group 13 nitride crystal obtained by the present invention are also governed by the speed of the thus-controlled reaction.

In the present invention, a composite nitride $Li_3GaN_2$ as the GaN raw material is dissolved in a molten salt of alkali metal halide to form a solution or melt, and the solid GaN can be precipitated from the solution or melt by lowering the temperature of the solution or melt or in a low-temperature place provided in the reaction system. At this time, $Li_3N$ remains dissolved in the molten salt. As for the alkali metal halide used as the solvent, those having affinity as large as forming a compound in thermoequilibrium with $Li_3N$ which is a by-product, are preferred because these also have large solubility. Incidentally, in formula (3), the equilibrium is shifted to the production-system side at a low temperature and therefore, a method where the dissolution part of causing $Li_3GaN_2$ to dissolve in the molten salt is set to a high temperature and the crystal growth portion is set to a relatively low temperature, is also preferred.

[Formula 7]

$$Li_3N + Ga = GaN + Li \qquad \text{formula (4)}$$

$$2Li_3N + Ga = Li_3GaN_2 + 3Li \qquad \text{formula (5)}$$

In the present invention, the temperature at the reaction for precipitating a Group 13 metal nitride crystal is usually from 200 to 1, 000°C, preferably from 400 to 850°C, more preferably from 600 to 800°C.

In the present invention, the pressure in the reaction vessel for precipitating a Group 13 metal nitride crystal is usually 10 MPa or less, preferably 3 MPa or less, more preferably 0.3 MPa or less, still more preferably 0.11 MPa or less.

In the present invention, a composite nitride is used by dissolving it in a molten salt and therefore, can be used at a temperature lower than the melting point of the composite nitride. Also, when an excess composite nitride is charged, this is preferred because the molten salt near the composite nitride comes to have a concentration equal to the saturation dissolution and the activity of $Li_3GaN_2$ in formula (3) becomes 1.

In the case of doping a substance other than Group 13 metal into the crystal, the substance may be dissolved in the form of a nitride in the molten salt and the purpose can be attained within the production step of the present invention.

$Li_3GaN_2$ may be produced by reacting GaN and $Li_3N$ at about 800°C or by heat-treating a Ga-Li alloy at 600 to 800°C in a nitrogen atmosphere or may also be produced by a method of reacting GaN and $Li_3N$ in an ionic solvent. In this method, the composite nitride produced is already dissolved in the ionic solvent to form a solution or a melt, and a solid in which the composite nitride and the ionic solvent are mixed is obtained by lowering the temperature of this solution or melt. When the mixed solid obtained is used as the raw material for crystal growth, this is advantageous in that a uniform solution or melt can be readily obtained as compared with the case of separately charging a composite nitride and an ionic solvent into the crystal growth apparatus. In another method, a mixed composition film of Li-N or Ga-Li-N may be formed by reactive sputtering using a nitrogen plasma with the target being an Li metal or a Ga-Li alloy and used in substitution for $Li_3GaN_2$. This is not only suitable for producing a thin-film crystal but also advantageous in that even a material system difficult to chemically synthesize can be produced.

As for the reaction vessel used at the production of $Li_3GaN_2$, a refractory material comprising an oxide containing a metal belonging to Groups 2 and 3 of the Periodic Table, specifically, Mg, Ca, Al, Ti, Y, Ce or the like, particularly, an inexpensive basic refractory material such as magnesium oxide, calcium oxide and zirconia, may be used.

The composite nitrides other than $Li_3GaN_2$ may also be produced by a method similar to the above-described method for $Li_3GaN_2$.

Generally, in the crystal growth from a liquid phase, the same powder or microcrystal as the product single crystal is used as the raw material. For example, in the case of producing a GaN single crystal, the preparation of the raw material GaN powder is expensive, but the process of the present invention uses a composite nitride producible at a low cost and therefore, is advantageous as an industrial process.

The Group 13 metal nitride crystal obtained by the production process of the present invention is a nitride of single metal (for example, GaN, AlN or InN) or a nitride of synthetic composition (for example, GaInN or GaAlN), and this production process can be suitably used in particular as a production process of GaN crystal. The crystal growth of the Group 13 metal nitride is preferably performed by growing the crystal on a seed or a substrate.

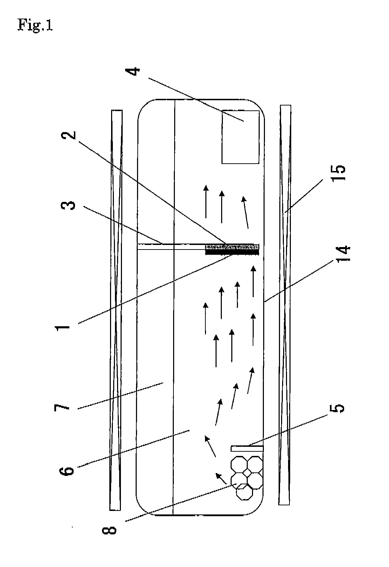

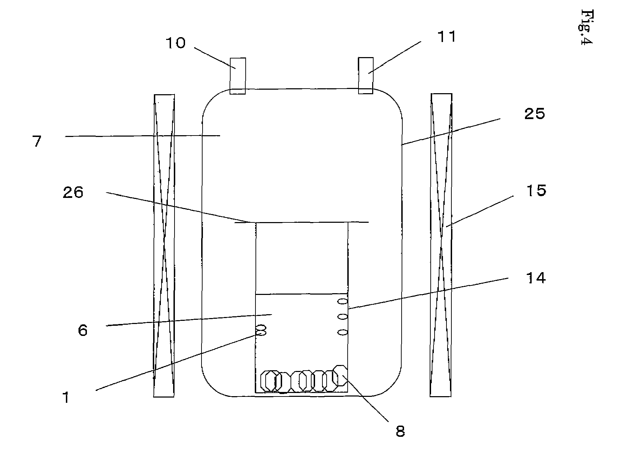

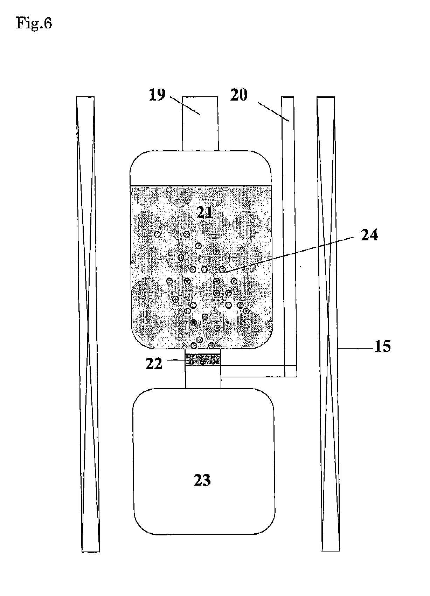

The production process of the present invention is described in greater detail below by referring to the drawings. Figs. 1 to 3 each is a view showing a construction example of the production apparatus for growing a Group 13 metal nitride crystal, which is used in practicing the present invention. Figs. 4, 5, 11 and 12 each is a view showing the apparatus used in Examples of the present invention. Fig. 6 is a schematic explanatory view of a purification apparatus for a molten salt, and the molten salt for use in the crystal growth is previously purified (mainly dehydration) by this apparatus.

The molten salt such as chloride generally contains a large amount of water due to its strong hygroscopicity. If a molten salt containing water is used in practicing the present invention, this is not preferred because an oxide of Group 13 metal is formed in the reaction vessel, or the reaction vessel is readily corroded. Accordingly, impurities such as water are preferably removed in advance by using a sample encapsulation-type pretreatment apparatus shown in Fig. 6 (see, Yoyu En, Netsu Gijutsu no Kiso (Molten Salt, Fundamentals of Thermal Technology), Agne Gijutsu Center, page 266). In purifying a molten salt by using the apparatus shown in Fig. 6, a metal salt intended to purify is placed in a purification vessel 21, and the metal salt is melted by elevating the temperature of an electric furnace 15 for salt purification apparatus in a vacuum or while vacuumizing the inside of the purification vessel 21 from a gas discharge port 19 and by further switching the system to an atmosphere of inert gas (e.g., argon gas) or reactive gas (e.g., hydrogen chloride gas). Thereafter, bubbling is performed for about 1 hour or more by blowing a reactive gas such as hydrogen chloride gas into the metal salt in a melted state from a gas inlet tube 20 through a porous filter 22. When bubbling is completed, the molten salt is transferred to a sample reservoir 23 by reducing the pressure on the gas inlet tube 20 side and, if desired, applying a pressure from the gas discharge port 19 side with use of an inert gas. After cooling, the sample reservoir 23 is put into a vacuum state and the top thereof is tightly sealed, whereby the purified sample is vacuum-enclosed and stored. In the case where the molten salt contains a heavy metal or the like unremovable by the above-described method, this salt is preferably further purified by a zone melt method.

The step of growing a Group 13 metal nitride crystal according to the production process of the present invention is specifically described below. The step is described here by taking, as an example, a case where a composite nitride $Li_3GaN_2$ comprising a Group 13 metal element and a metal element other than Group 13 is used as the raw material, an LiCl molten salt purified by the apparatus shown in Fig. 6 is used as the molten salt, and Ga is used for reducing the concentration of $Li_3N$ which is a nitrogen compound of the above-described metal element other than Group 13 metal. The description in the following can apply to the case of selecting other materials.

Fig. 1 is a schematic view of a typical production apparatus used in practicing the present invention. A purified LiCl salt 6 is charged into a reaction vessel 14 made of magnesium oxide or calcium oxide and dissolved at 650 to 780°C. A previously produced $Li_3GaN_2$ composite nitride 8 is placed in a portion divided by a partition plate 5 and dissolved in the molten salt 6. The dissolved $Li_3GaN_2$ composite nitride is considered to dissolve while forming a complex salt with the solvent LiCl. In this state, the composite nitride reaches the surface of a GaN crystal 1, and a GaN crystal grows by the reaction of formula (3), causing increase in the concentration of $Li_3N$ as a by-product in the periphery thereof. In order to accelerate uniform crystal growth on the crystal surface, the $Li_3N$ concentration in the solution or melt is also preferably uniform and therefore, it is preferred to gently move the GaN crystal 1 in the solution or melt by moving a substrate 2 and a substrate-holding mechanism 3. In the case where the amount of the molten salt is sufficiently large and the thickness of the GaN crystal 1 grown need not be so large, the reaction may be continued until the crystal growth naturally stops due to elevation in the $Li_3N$ concentration along the crystal growth. However, in order to grow a large bulk crystal, as shown in Fig. 1, a Ga metal is preferably placed in the rear of the GaN crystal 1. $Li_3N$ of which concentration is elevated in the vicinity of the crystal growth part reacts with the Ga metal according to formula (4) to become a GaLi alloy and at the same time, produces GaN and $Li_3GaN_2$ in the vicinity of the GaLi alloy surface. This $Li_3GaN_2$ again works as the raw material for epitaxial growth of the crystal. As long as the raw material $Li_3GaN_2$ is present, the GaN crystal can be continuously grown. On the low temperature side, the equilibrium of formula (4) shifts to the production side (right side). Therefore, when the $Li_3GaN_2$ dissolving portion is set to a high temperature and the crystal growth portion is set to a low temperature, this is in that the crystallization rate increases.

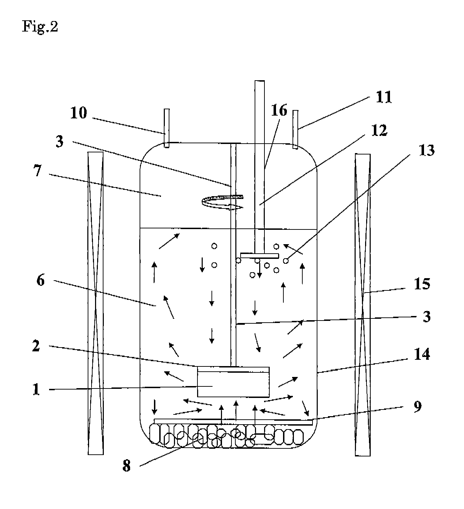

Fig. 2 shows a crystal growth apparatus in another vertical mode suitable for practicing the present invention. A molten salt 6 having a low melting point, such as purified LiCl or binary eutectic salt LiCl-NaCl, is charged into a reaction vessel 14 made of magnesium oxide or calcium oxide. A separately produced $Li_3GaN_2$ composite nitride 8 is covered with a tungsten net 9 and sunk to the bottom of the reaction vessel 14, and a seed 2 fixed to a tip of a substrate-holding bar 3 having a rotating function is placed above the composite nitride. Then, a GaN crystal precipitates from a solution or melt having dissolved therein $Li_3GaN_2$ and epitaxial growth from a liquid phase takes place. When the GaN crystal grows on the crystal surface, the $Li_3N$ component increases in the solution or melt and partially moves up on the flow of solution or melt in the arrow direction shown in the Figure along the rotation of crystal to increase the concentration of $Li_3N$ component in the solution or melt. In the case of growing a thin-film crystal on the seed, it may suffice to increase the amount of solution or melt, but for continuously growing a bulk crystal, the $Li_3N$ component in the solution or melt needs to be continuously removed. In Fig. 2, hydrogen chloride is blown into the solution or melt from a gas blowing tube 12 to decompose the $Li_3N$ component into LiCl, $N_2$ and $H_2$. Alternatively, when milder conditions are intended, by using nitrogen or argon as a carrier gas, an ammonium chloride gas may be introduced from gas inlet tubes 10 and 11 into the reaction vessel 14, so that hydrogen chloride produced by decomposition can diffuse into the molten salt from the solution or melt interface.

As for the seed 2, sapphire, Sic or the like may be used, but a plate-like GaN crystal is preferably used. It is preferred to homoepitaxially grow a GaN crystal on a plate-like GaN crystal, prepare several sheets of wafer therefrom, and use one of these sheets as a substrate for the next crystal growth.

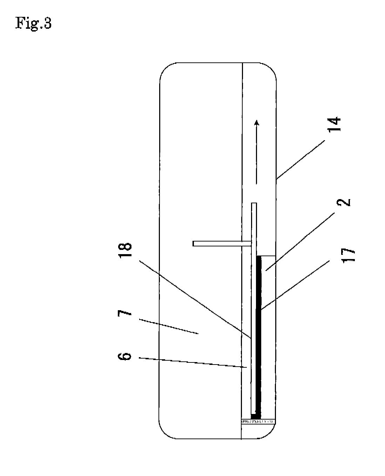

In Fig. 3, a thin film 17 comprising a mixture such as Ga-Li-N is formed on a substrate 2 such as quartz, sapphire or GaN by using a dry process such as sputtering and dissolved in an LiCl molten salt 6, and a GaN crystal is grown on the substrate 2. In the Figure, 18 is a partition plate for preventing reaction between the nitride thin film 17 and the LiCl molten salt 6 from occurring outside the crystal growth portion, and tungsten or the like is used as the material therefor. The atmosphere 7 in the reaction vessel 14 is an inert atmosphere such as nitrogen or argon. The dissociation pressure of the produced GaN becomes 1 atm at 650°C as calculated from the free energy of production, and decomposition is generally considered to start when the temperature reaches 650°C or more under atmospheric pressure. However, according to the present invention, even at a temperature of 600 to 800°C under atmospheric pressure, GaN in the molten salt is not decomposed into Ga metal and nitrogen gas or the like. Furthermore, as apparent from formula (3), the dissolution and precipitation of GaN crystal can be controlled by the $Li_3N$ concentration in the molten salt and therefore, re-dissolution and recrystallization can be repeated at the solid-liquid interface for crystal growth, as a result, the crystal quality can be enhanced. In this way, the present invention is remarkably advantageous.

[Production Method of Semiconductor Device]

The production process of the present invention can be used for the step of producing a Group 13 metal nitride crystal in the production method of a semiconductor device. With respect to the raw materials, production conditions and apparatus in other steps, the raw materials, conditions and apparatus used in a general production method of a semiconductor device can be applied directly.

Examples

The characteristic features of the present invention are described in greater detail below by referring to Examples. The materials, amounts used, ratios, treatment contents, treatment procedures and the like described in the following Examples can be appropriately changed or modified without departing from the purport of the present invention. Accordingly, the scope of the present invention should not be construed as being limited to these specific examples.

(Production Example) Synthesis of Composite Nitride:

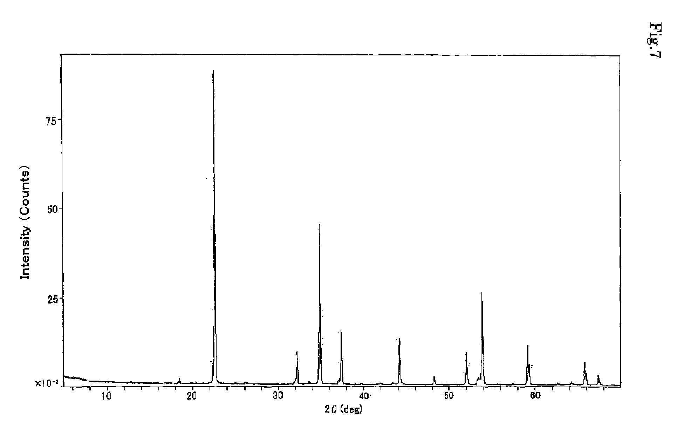

Polycrystalline gallium nitride and lithium nitride reagents (produced by Mitsuwa Chemicals Co., Ltd.) were mixed in a mortar to a molar ratio of about 1 ; 1, and about 2 g of the resulting mixture was charged into a magnesia-made reaction vessel (crucible) and fired under nitrogen flow of 60 Nml/min to produce a composite nitride- As for the firing temperature control, the temperature was elevated to 800°C in 1 hour from room temperature and after holding at 800°C for 20 hours, the electric furnace power supply was turned off to allow natural cooling. The sample had a mixed color of gray and red-purple before the firing but turned to whitish gray after the firing. Fig. 7 shows the X-ray data of this sample and it is seen that $Li_3GaN_2$ was produced.

(Example 1)

Using an apparatus shown in Fig. 4, an $Li_3GaN_2$ composite nitride 8 was sunk in a molten salt 6 comprising LiCl to perform the crystal growth of GaN without use of GaN seed, substrate or the like. LiCl (1.0 g) as the molten salt and about 0.15 g of the composite nitride $Li_3GaN_2$ were charged into an MgO-made first reaction vessel (crucible) 14 and subsequently, the insides of the first reaction vessel 14 and a quartz $(SiO_2)$ -made second reaction vessel 25 housing the first reaction vessel were set to an argon atmosphere (atmospheric pressure). The molar ratio of Li to Ga in the system was 22. Incidentally, LiCl was used by purifying the salt according to the description above with use of an apparatus shown in Fig. 6.

The temperature of the second reaction vessel 25 housing the first reaction vessel 14 was elevated to 780°C in 1 hour by using an electric furnace 15. As shown in Fig. 4, since the density of $Li_3GaN_2$ is larger than that of LiCl, the composite nitride was sunk to the bottom of the first reaction vessel 14. This state was held at 780°C for 8 hours and then, the temperature was lowered to 660°C at a rate of 12°C per hour. As shown in Fig. 4, the top of the first reaction vessel 14 was properly closed and almost no pressure difference was present between the inside and the outside of the first reaction vessel, so that the volatile components in the vessel could not be expelled outside the vessel. Thereafter, the electric furnace power supply was turned off, and the system was allowed to naturally cool. The firing was performed under nitrogen flow of 60 Nml/min at atmospheric pressure. After the completion of test, the system was cooled to an ordinary temperature in a stationary state. The contents in the first reaction vessel 14 were dissolved in water and filtered, and the solid matter was further dissolved out with concentrated hydrochloric acid. The transparent crystalline powder showed a sign of being grown from the inside of the first reaction vessel 14.

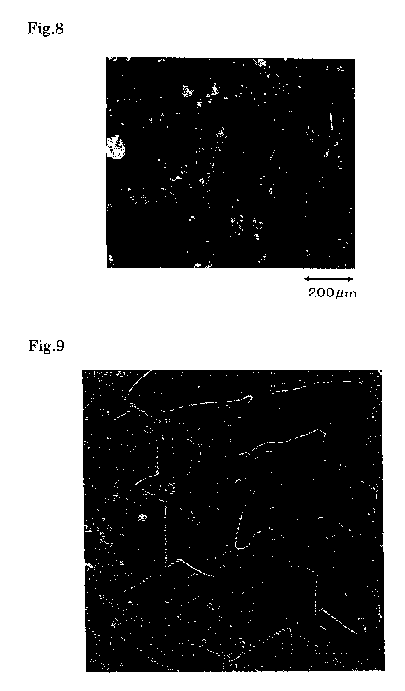

Fig. 8 shows an optical micrograph of the GaN crystal thus taken out. The yield was 9 mg. It is seen that a highly transparent colorless plate-like crystal having a size of 100 $\mu$m is grown.

(Example 2)

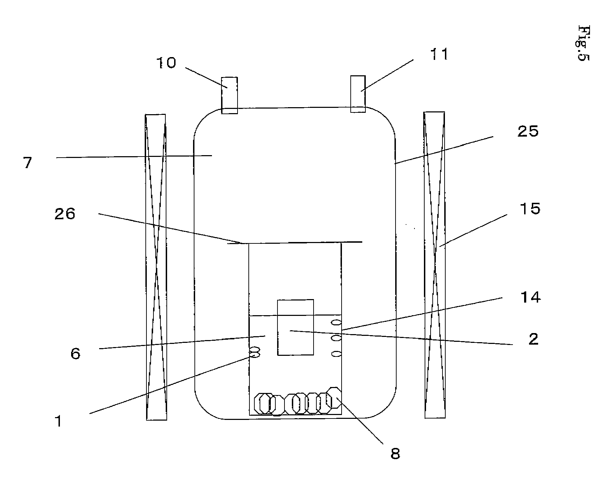

The crystal growth of GaN was performed under the same conditions as in Example 1 except that an apparatus shown in Fig. 5 was employed, 0.15 g of $Li_3GaN_2$ and 3.0 g of LiCl were used, and a GaN thin film produced as a seed crystal by a vapor phase process (MOCVD and H-VPE methods) was dipped as a seed 2 in the molten salt. Fig. 9 shows an SEM photograph of GaN grown on the seed surface. This shows a sign that a hexagonal crystal is grown on the surface and the crystal is epitaxially grown from a liquid phase on GaN produced by a vapor phase process.

(Example 3)

The crystal growth of GaN was performed under the same conditions as in Example 1 except that the amount of LiCi in the system was changed to 3.0 g and the molar ratio of Li to Ga was changed to 60. The yield was 12 mg, and the crystal was a mixture of a plate-like crystal and a columnar crystal.

(Example 4)

The crystal growth of GaN was performed under the same conditions as in Example 1 except that 0.017 g of $Li_3N$ was added, the gradual cooling rate was changed to 1°C/h, and the lower limit of the temperature range at the gradual cooling was changed to 730°C. The yield was 3 mg, and a thin plate-like crystal was obtained. The size of the crystal was about 500 $\mu$m.

(Example 5)

The crystal growth of GaN was performed under the same conditions as in Example 1 except that 1.1 g of an eutectic salt of LiCl and NaCl (Li:Na = 85:15 by mol) was used in place of LiCl, 0.007 g of $Li_3N$ was added, the holding time at 780°C was changed to 14 hours, the gradual cooling rate was changed to 1°C/h, and the lower limit of the temperature range at the gradual cooling was changed to 730°C. The yield was 37 mg. A columnar crystal having a length of about 700 $\mu$m and a size of about 150 $\mu$m was obtained.

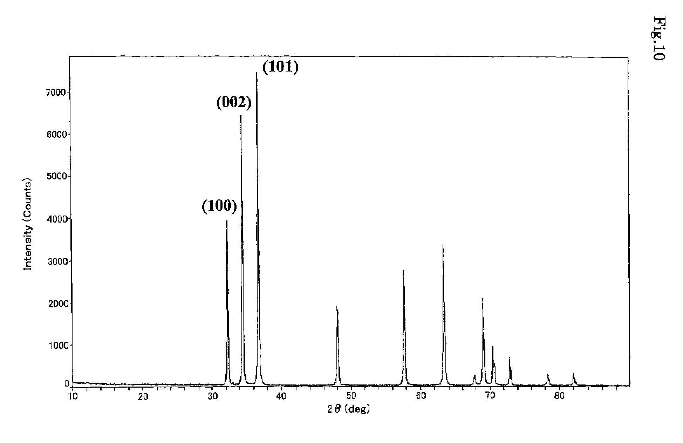

Fig. 10 shows the X-ray diffraction data. The half -value widths of representative diffraction peaks in the X-ray diffraction data of the obtained crystal are shown in Table 1.

[Table 1]

| Index | 2θ | Half-Value Width |
|-------|--------|------------------|
| 100 | 32.252 | 0.119 |
| 002 | 34.442 | 0.122 |
| 101 | 36.729 | 0.127 |

(Example 6)

The crystal growth of GaN was performed under the same conditions as in Example 5 except that the gradual cooling rate was changed to 2°C/h. The yield was 4 mg. A columnar crystal having a length of about 1. 7 mm and a size of 50 $\mu$m was obtained.

(Example 7)

The crystal growth of GaN was performed under the same conditions as in Example 1 except that the amount of LiCl was changed to 0.3 g and the amount of Li$_3$GaN$_2$ was changed to 0.3 g (the molar ratio of Li to Ga was 3). The amount of the crystal obtained was 1 mg or less, and the size of the crystal was from 5 to 10 $\mu$m.

(Example 8)

The crystal growth of GaN was performed under the same conditions as in Example 1 except that the amount of LiCl was changed to 5.0 g (the molar ratio of Li to Ga was 97). The amount of the crystal obtained was 1 mg or less, and the size of the crystal was from 5 to 10 $\mu$m.

(Example 9)

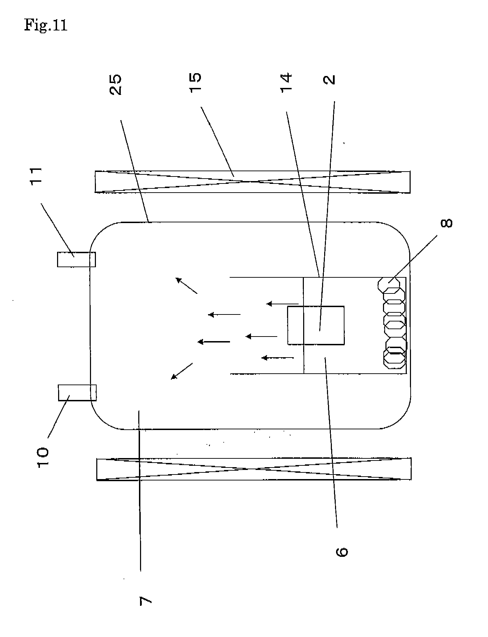

Using an apparatus shown in Fig. 11, 2.5 g of LiCl and 0.4 g of Li$_3$GaN$_2$ composite nitride were thoroughly mixed and charged into an MgO-made first reaction vessel (a crucible having an inner diameter of 25 mm and a height of 90 mm) 14. subsequently, a GaN substrate (0.5 mm $\times$ 0.5 mm) produced as a seed crystal by a vapor phase process (MOCVD and H-VPE methods) was dipped as a seed 2 in the first reaction vessel 14. Nitrogen was flowed at a flow rate of 70 ml/min into a quartz (SiO$_2$)-made second reaction vessel 25 housing the first reaction vessel 14. The molar ratio of Li to Ga in the system was 22.
The temperature of the second reaction vessel 25 housing the first reaction vessel 14 was elevated to 760°C in 1 hour from room temperature by using an electric furnace 15. As shown in Fig. 11, the first reaction vessel 14 was properly opened to the nitrogen atmosphere, and the volatile components in the first reaction vessel including Li$_3$N were gradually evaporated and expelled from the first reaction vessel. This state was held at 760°C for 20 hours and thereafter, the second reaction vessel 25 with the first reaction vessel 14 housed therein was taken out from the electric furnace and rapidly cooled. After the completion of test, the system was cooled to an ordinary temperature in a stationary state, the contents in the first reaction vessel 14 were dissolved in water and filtered, and the solid matter was further dissolved out with concentrated hydrochloric acid. The crystal growth of GaN was confirmed on the surface of the charged seed crystal substrate after the completion of reaction, and the growth thickness was 3 $\mu$m. The obtained single crystal weighed 63 mg and was a plate-like columnar crystal having a size of about 500 $\mu$m.

(Example 10)

The crystal growth of GaN was performed under the same conditions as in Example 9 except that the amount of LiCl was changed to 5 g.
The crystal growth of GaN was confirmed on the surface of the charged seed crystal substrate after the completion of reaction, and the growth thickness was 4 $\mu$m. The obtained single crystal weighed 84 mg and was a plate-like columnar crystal having a size of about 500 $\mu$m.

(Example 11)

The crystal growth of GaN was performed under the same conditions as in Example 9 except that 0.04 g of

Li$_3$N was added to the raw material.

The single crystal obtained after the completion of reaction weighed 32 mg, the crystal growth of GaN was confirmed on the surface of the charged seed crystal substrate, and the growth thickness was 4 $\mu$m.

(Example 12)

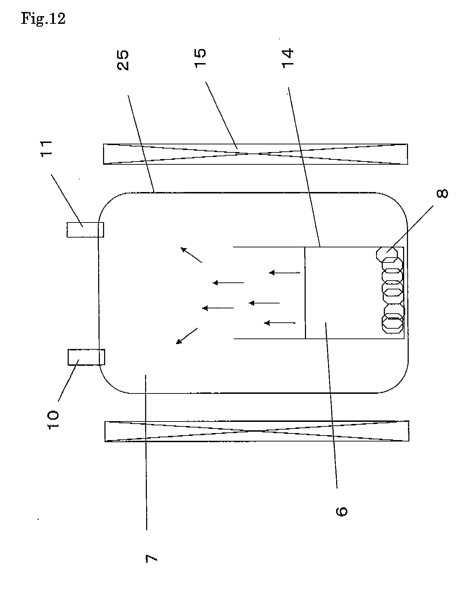

The crystal growth of GaN was performed under the same conditions as in Example 9 except that an apparatus shown in Fig. 12 was employed and a seed crystal was not dipped.

The single crystal obtained after the completion of reaction weighed 62 mg and was a plate-like columnar crystal having a size of about 500 $\mu$m.

(Example 13)

The crystal growth of GaN was performed under the same conditions as in Example 9 except that the reaction temperature was changed to 715°C.

The single crystal obtained after the completion of reaction weighed 1 mg, the crystal growth of GaN was confirmed partially on the surface of the charged seed crystal substrate, and the thickness in the growth part was 1 $\mu$m.

(Example 14)

The crystal growth of GaN was performed under the same conditions as in Example 9 except that the holding time for reaction was changed to 10 hours.

The single crystal obtained after the completion of reaction weighed 10 mg, and the crystal growth of GaNwas confirmed partially on the surface of the charged seed crystal substrate.

(Example 15)

The crystal growth of GaN was performed under the same conditions as in Example 9 except that the amount of LiCl was changed to 2.5 g and the holding time for reaction was changed to 40 hours.

The single crystal obtained after the completion of reaction weighed 63 mg, the crystal growth of GaN was confirmed partially on the surface of the charged seed crystal substrate, and the growth thickness was 5 $\mu$m.

(Example 16)

The crystal growth of GaN was performed under the same conditions as in Example 9 except that a W net was put on the bottom of the first reaction vessel 14.

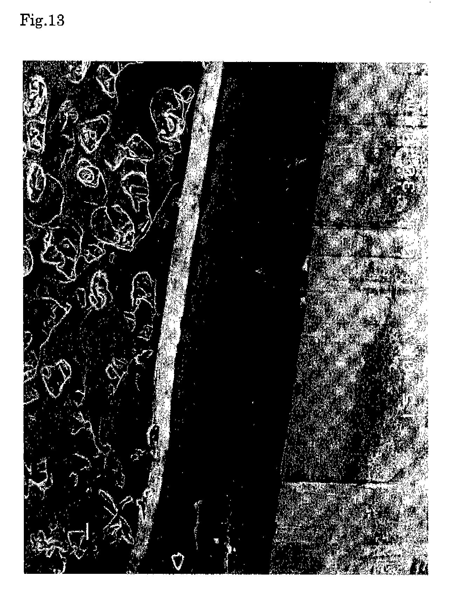

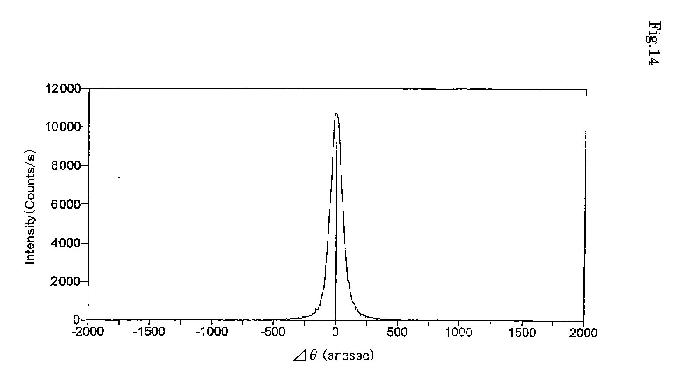

The single crystal obtained after the completion of reaction weighed 68 mg, the crystal growth of GaN was confirmed partially on the surface of the charged seed crystal substrate, and the growth thickness was 5 $\mu$m. Fig. 13 shows an SEM image of the cross-section of the growth part where the crystal was grown on the seed crystal. Also, Fig. 14 shows the X-ray rocking curve measurement results of the (002) plane of GaN grown on the seed crystal ($\omega$=15.505 deg, half-value width = 106.2 arcsec, strength = 10766.7 cps).

(Example 17)

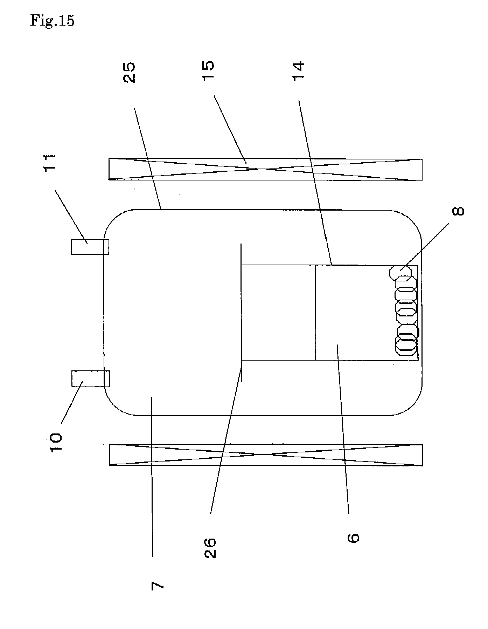

Using an apparatus shown in Fig. 15, 0.2 g of Li$_3$GaN$_2$ and 3 g of LiCl were charged into an MgO-made first reaction vessel 14. Subsequently, nitrogen was flowed at a flow rate of 70 ml/min into a quartz (SiO$_2$) -made second reaction vessel 25 housing the first reaction vessel 14.

The temperature of the second reaction vessel 25 housing the first reaction vessel 14 was elevated to 775°C in 1 hour from room temperature by using an electric furnace 15, and the system was held at that temperature for 20 hours. As shown in Fig. 15, a lid 26 was put on the first reaction vessel 14, and the volatile components in the first reaction vessel including Li$_3$N were not expelled from the first reaction vessel.

After the completion of reaction, the second reaction vessel 25 with the first reaction vessel 14 housed therein was taken out from the electric furnace and rapidly cooled. The analysis of elements in the molten salt after solidification was performed, as a result, the Ga concentration contained in the molten salt was 0.13 mol%, the nitrogen concentration was 0.4 mol%, and the value of K in formula (1) determined from the nitrogen concentration in the molten salt was 1.26.

(Example 18)

The test was performed under the same conditions as in Example 17 except for employing an apparatus shown in Fig. 11, As shown in. Fig. 11, the first reaction vessel 14 was opened to the nitrogen atmosphere, and the volatile components in the first reaction vessel including $Li_3N$ were gradually evaporated and expelled from the first reaction vessel.
The single crystal obtained after the completion of reaction weighed 17 mg.

(Example 19)

The test was performed under the same conditions as in Example 17 except for holding the system at 765°C for 20 hours.
The analysis of elements in the molten salt solidified by rapid cooling after the completion of reaction was performed, as a result, Ga contained in the molten salt was 0.1 mol%, the nitrogen concentration was 0.25 mol%, and the value of Kin formula (1) determined from the nitrogen concentration in the molten salt was 0.79.

(Example 20)

The test was performed under the same conditions as in Example 19 except for employing an apparatus shown in Fig. 11.
The single crystal obtained after the completion of reaction weighed 6 mg.

(Example 21)

The test was performed under the same conditions as in Example 17 except for using a $Y_2O_3$-made first reaction vessel and holding the system at 760°C for 20 hours.
The analysis of elements in the molten salt solidified by rapid cooling after the completion of reaction was performed, as a result, Ga contained in the molten salt was 0.01 mol%, the nitrogen concentration was 0.11 mol%, and the value of Kin formula (1) determined from the nitrogen concentration in the molten salt was 0.33.

(Example 22)

The test was performed under the same conditions as in Example 21 except for employing an apparatus shown in Fig. 11.
The single crystal obtained after the completion of reaction weighed 6 mg.

(Example 23)

The test was performed under the same conditions as in Example 21 except for holding the system at 660°C for 20 hours.
The analysis of elements in the molten salt solidified by rapid cooling after the completion of reaction was performed, as a result, Ga contained in the molten salt was 0.006 mol%, the nitrogen concentration was 0.044 mol%, and the value of K in formula (1) determined from the nitrogen concentration in the molten salt was 0-14.

(Example 24)

The test was performed under the same conditions as in Example 23 except for employing an apparatus shown in Fig. 11.
The single crystal obtained after the completion of reaction weighed 1 mg.

(Comparative Example 1)

The test was performed under the same conditions as in Example 17 except for charging 0.2 g of GaN and 3 g of LiCl into the first reaction vessel 14.
The analysis of elements in the molten salt solidified by rapid cooling after the completion of reaction was performed, as a result, the Ga concentration contained in the molten salt was below the detection limit (0.002 mol% or less) and very low, indicating that GaN was not dissolved in the solution or melt.

(Comparative Example 2)

The test was performed under the same conditions as in Example 9 except that an apparatus shown in Fig. 15 was employed, 1 g of LiCl, 0.15 g of $Li_3GaN_2$ composite nitride and 0.017 g of $Li_3N$ were thoroughly mixed and charged into an MgO-made first reaction vessel (inner diameter: 9 mm, height: 60 mm) 14, and the reaction temperature was changed to 780°C.

The surface area of solution was small due to the narrow inner diameter of the first reaction vessel 14 and since the reaction was performed with a lid 26 on, evaporation of $Li_3N$ was suppressed. After the completion of reaction, precipitation of a GaN single crystal was not observed.

INDUSTRIAL APPLICABILITY

According to the production process of a Group 13 metal nitride crystal of the present invention using the solution or melt of the present invention, a Group 13 metal nitride crystal having a sufficiently large size for the application to a semiconductor device can be easily produced by using an inexpensive apparatus. In particular, the present invention can be utilized for the production of a semiconductor device capable of coping with a frequency which had been heretofore difficult to produce, and this is greatly advantageous in industry.

**Claims**

1. A process for producing a Group 13 metal nitride crystal, comprising dissolving a composite nitride containing a metal element belonging to Group 13 of the Periodic Table and a metal element other than Group 13 of the Periodic Table in an ionic solvent to prepare a solution or a melt, and performing the growth of a Group 13 metal nitride crystal in said solution or melt.

2. The process for producing a Group 13 metal nitride crystal as claimed in claim 1, wherein said ionic solvent mainly comprises a molten salt.

3. The process for producing a Group 13 metal nitride crystal as claimed in claim 2, wherein said molten salt is one kind of metal halide or multiple kinds of metal halides.

4. The process for producing a Group 13 metal nitride crystal as claimed in any one of claims 1 to 3, wherein the metal element other than Group 13 of the Periodic Table contained in said composite nitride is contained also in said ionic solvent.

5. The process for producing a Group 13 metal nitride crystal as claimed in any one of claims 1 to 4, wherein the ratio of the total molar number of the metal element other than Group 13 of the Periodic Table contained in said solution or melt to the total molar number of the metal element belonging to Group 13 of the Periodic Table contained in said solution or melt is from 16 to 80.

6. The process for producing a Group 13 metal nitride crystal as claimed in any one of claims 1 to 5, wherein the nitride of the metal element other than Group 13 of the Periodic Table contained in said composite nitride dissolves at a concentration of 1.0 mol% or more in said ionic solvent.

7. The process for producing a Group 13 metal nitride crystal as claimed in any one of claims 1 to 6, wherein a Group 13 metal nitride crystal is grown by lowering the temperature of the solution or melt obtained after dissolving said composite nitride in said ionic solvent.

8. The process for producing a Group 13 metal nitride crystal as claimed in any one of claims 1 to 7, wherein the dissolution site of causing said composite nitride to dissolve in said ionic solvent and the crystal growth site of allowing said Group 13 metal nitride crystal to grow are separated, and the temperature of said dissolution site is higher than the temperature of said growth site.

9. The process for producing a Group 13 metal nitride crystal as claimed in any one of claims 1 to 8, wherein said Group 13 metal nitride crystal is grown on the surface of a seed crystal or on a substrate.

10. The process for producing a Group 13 metal nitride crystal as claimed in any one of claims 1 to 9, wherein the metal nitride component other than said Group 13 metal in said solution or melt is removed from the crystal growth site of allowing said Group 13 metal nitride crystal to grow.

11. The process for producing a Group 13 metal nitride crystal as claimed in claim 10, wherein the metal nitride component other than said Group 13 metal in said solution or melt is removed by evaporation, reaction, decomposition or diffusion from the crystal growth site.

12. The process for producing a Group 13 metal nitride crystal as claimed in any one of claims 1 to 11, wherein the metal element other than said Group 13 metal is an alkali metal element or an alkaline earth metal element.

13. The process for producing a Group 13 metal nitride crystal as claimed in any one of claims 1 to 12, wherein the growth of a Group 13 metal nitride crystal is performed in a state of the solid phase of said composite nitride remaining in the crystal growth apparatus containing said solution or melt.

14. The process for producing a Group 13 metal nitride crystal as claimed in any one of claims 1 to 13, wherein said crystal growth is performed in a reaction vessel comprising, as the main component, an oxide of an element belonging to Group 2 or Group 3 of the Periodic Table.

15. The process for producing a Group 13 metal nitride crystal as claimed in claim 14, wherein said reaction vessel mainly comprises an oxide having a standard formation energy of -930 kJ/mol or less at 1,000K.

16. The process for producing a Group 13 metal nitride crystal as claimed in any one of claims 1 to 15, wherein said crystal growth is performed under atmospheric pressure.

17. The process for producing a Group 13 metal nitride crystal as claimed in any one of claims 1 to 16, wherein said crystal growth is performed in an argon atmosphere.

18. The process for producing a Group 13 metal nitride crystal as claimed in any one of claims 1 to 17, wherein a doping element is caused to be present in said solution or melt to thereby grow a Group 13 metal nitride crystal doped with said element.

19. A process for producing a Group 13 metal nitride crystal, comprising performing the growth of a Group 13 metal nitride crystal in a solution or melt having a nitrogen concentration $X_N$ represented by the following formula (1):

$$X_N = K \cdot P^{1/2} \qquad \text{formula (1)}$$

wherein $X_N$ is a nitrogen concentration (mol%) in said solution or melt, K is a proportionality constant represented by the following formula (2), and P is a pressure (MPa) in the crystal growth apparatus containing said solution or melt,

$$K \geq 0.001T - 0.85 \qquad \text{formula (2)}$$

wherein T is a temperature (K) of said solution or melt.

20. The process for producing a Group 13 metal nitride crystal as claimed in claim 19, wherein the growth of a Group 13 metal nitride crystal is performed at 10 MPa or less.

21. The process for producing a Group 13 metal nitride crystal as claimed in claim 19 or 20, wherein the growth of a Group 13 metal nitride crystal is performed at 600 to 1,000°C.

22. The process for producing a Group 13 metal nitride crystal as claimed in any one of claims 19 to 21, wherein said solution or melt is a solution or melt comprising an ionic solvent having dissolved therein a composite nitride containing a metal element belonging to Group 13 of the Periodic Table and a metal element other than Group 13 of the Periodic Table.

23. A method for producing a semiconductor device, comprising producing a Group 13 metal nitride crystal by the production process claimed in any one of claims 1 to 22.

24. A solution or melt comprising an ionic solvent having dissolved therein a composite nitride containing a metal element belonging to Group 13 of the Periodic Table and a metal element other than Group 13 of the Periodic Table.

Fig.1

Fig.2

Fig.3

Fig.4

Fig.5

Fig.6

Fig.7

Fig.8

200 μm

Fig.9

Fig.10

Fig.11

Fig.12

Fig.13

Fig.14

Fig.15

<table>
<tr><td colspan="2" align="center">**INTERNATIONAL SEARCH REPORT**</td><td>International application No.<br>PCT/JP2006/315955</td></tr>
</table>

| A. CLASSIFICATION OF SUBJECT MATTER |
| --- |
| *C01B21/06*(2006.01)i, *C30B9/12*(2006.01)i, *C30B29/38*(2006.01)i, *H01L33/00*(2006.01)i |

According to International Patent Classification (IPC) or to both national classification and IPC

| B. FIELDS SEARCHED |
| --- |
| Minimum documentation searched (classification system followed by classification symbols)<br>C01B21/06, C30B9/12, C30B29/38, H01L33/00 |

| Documentation searched other than minimum documentation to the extent that such documents are included in the fields searched |
| --- |
| Jitsuyo Shinan Koho 1922-1996 Jitsuyo Shinan Toroku Koho 1996-2006<br>Kokai Jitsuyo Shinan Koho 1971-2006 Toroku Jitsuyo Shinan Koho 1994-2006 |

| Electronic data base consulted during the international search (name of data base and, where practicable, search terms used) |
| --- |
| |

C. DOCUMENTS CONSIDERED TO BE RELEVANT

| Category* | Citation of document, with indication, where appropriate, of the relevant passages | Relevant to claim No. |
| --- | --- | --- |
| A | JP 2005-206403 A (Japan Science and Technology Agency),<br>04 August, 2005 (04.08.05),<br>Claims; examples; Par. Nos. [0028] to [0033]<br>& WO 2005/071143 A1 | 1-24 |
| A | JP 2005-154254 A (Sumitomo Electric Industries, Ltd.),<br>16 June, 2005 (16.06.05),<br>Claims; examples; Par. Nos. [0026] to [0027]<br>& US 2005/0098090 A1 & EP 1538241 A2 | 1-24 |
| A | JP 2005-206415 A (Ricoh Co., Ltd.),<br>04 August, 2005 (04.08.05),<br>Claims; examples; Par. Nos. [0040] to [0042]<br>(Family: none) | 1-24 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>08 November, 2006 (08.11.06) | Date of mailing of the international search report<br>28 November, 2006 (28.11.06) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
|---|
| PCT/JP2006/315955 |

C (Continuation).   DOCUMENTS CONSIDERED TO BE RELEVANT

| Category* | Citation of document, with indication, where appropriate, of the relevant passages | Relevant to claim No. |
|---|---|---|
| P,A | JP 2005-263511 A  (Ricoh Co., Ltd.),<br>29 September, 2005 (29.09.05),<br>Claims; examples<br>(Family: none) | 1-24 |
| A | JP 2-115034 A  (Showa Denko Kabushiki Kaisha),<br>27 April, 1990 (27.04.90),<br>Claims; examples; page 3, lower right column,<br>line 8 to page 4, upper left column, line 12<br>(Family: none) | 1-24 |
| A | JP 2-55283 A  (Nippon Telegraph And Telephone<br>Corp.),<br>23 February, 1990 (23.02.90),<br>Claims; examples<br>(Family: none) | 1-24 |
| A | JP 2004-307322 A  (Ricoh Co., Ltd.),<br>04 November, 2004 (04.11.04),<br>Claims; examples<br>& US 2004/0226503 A1 | 1-24 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005112718 A
- CN 1288079 A
- JP 2005306709 A
- CN 1286079 A

### Non-patent literature cited in the description

- *J. Appl. Phys.,* 1998, vol. 37, 309
- *J. Crystal Growth,* 1977, vol. 178, 174
- *J. Crystal Growth,* 2000, vol. 218, 712
- *Kinzoku (Metals),* 2003, vol. 73 (11), 1, 060
- *Acta Physica Polonica A,* 1995, vol. 88, 137
- *J. Crystal Growth,* 2005, vol. 281, 5
- *J. Mater. Sci. Ele.,* 2005, vol. 16, 29
- *J. Crystal Growth,* 2005, vol. 284, 91
- *J. Crystal Growth,* 2003, vol. 247, 275-278